Europäisches Patentamt

European Patent Office

Office européen des brevets

(11) Publication number: **0 418 983 A1**

## EUROPEAN PATENT APPLICATION

(21) Application number: **90202500.6**

(51) Int. Cl.⁵: **H01L 21/86, H01L 21/336**

(22) Date of filing: **20.09.90**

(30) Priority: **21.09.89 NL 8902372**

(43) Date of publication of application:
**27.03.91 Bulletin 91/13**

(84) Designated Contracting States:
**AT BE CH DE DK ES FR GB GR IT LI LU NL SE**

(71) Applicant: **INTERUNIVERSITAIR
MICRO-ELECTRONICA CENTRUM VZW
Kapeldreef 75
B-3030 Leuven-Heverlee(BE)**

(72) Inventor: **Colinge, Jean-Pierre
Rue de Bonne-Espérance, 4/202
B-1348 Louvain-Pa-Neuve(BE)**

(74) Representative: **Land, Addick Adrianus
Gosling et al
OCTROOIBUREAU ARNOLD & SIEDSMA
Sweelinckplein 1
NL-2517 GK Den Haag(NL)**

(54) **Method of manufacturing a field effect transistor and a semiconductor element.**

(57) A method for manufacturing a FET which comprising the steps of arranging a gate under and above the channel. A FET has a gate around the channel.

FIG.5

## METHOD OF MANUFACTURING A FIELD EFFECT TRANSISTOR AND A SEMICONDUCTOR ELEMENT

Integrated circuits for use in environments where radiation occurs are usually constructed from SOI circuits as the effect of radiation is comparatively small due to the relatively small value of charge released through radiation.

When the radiation doses are large (for instance 1 Mrad (Si)), the thickness of the underlying oxide also becomes a problem in the case of SOI circuits. At a thickness of 100-200 nm a charge is generated herein such that the threshold voltage is affected, with the consequent loss of good operation.

An object of the present invention is to avoid the above stated disadvantages.

The present invention therefore provides a method according to claim 1, in addition to a semiconductor element as according to claims 4 and 5.

Different theoretical studies have shown that thin-film Silicon-On-Insulator (SOI) devices with a gate electrode both above and below the active silicon film would allow one to obtain extremely interesting electrical properties such as high transconductance and reduced short-channel effects. In the conventional MOSFET, the active silicon film sits on top of a 400 nm-thick buried oxide layer (SIMOX material), and the underlying silicon substrate can be used as a back gate. In the proposed "Gate-All-Around" structure according to the present invention, the active silicon sits on a thin, gate-quality oxide and on a polysilicon gate electrode. Because of the extremely good control of the charges within the active silicon when top and bottom (T&B) gate is provided, significant short-channel threshold rolloff has been predicted in devices with T&B gate. In addition, it has been found theoretically that the thin silicon film in which T&B gate devices are made can become completely inverted when a gate voltage is applied (i.e.: inversion is not confined within top and bottom inversion channels, but the entire film becomes inverted at all depth x in the silicon film. This particularity provides the device with enhanced transconductance performances, since inversion within the volume of the silicon presents less scattering than surface inversion. A third advantage of this type of device is its potentially high total-dose hardness. Indeed, the threshold shift induced in a MOSFETT by exposure to dose irradiation is proportional to the square of the thickness of the oxide in contact with the active silicon. In conventional SOI MOSFET's, the buried oxide underneath the device has a thickness of 400 nm, typically. Charges are created in this relative thick oxide by dose exposure and cause important threshold shifts in thin-film devices. In the T&B gate device proposed here, the active part of the device is only in contact with thin, gate-quality oxide, which should minimize radiation-induced threshold voltage shifts.

Further advantages, features and details will become apparent in the light of a detailed description of a preferred embodiment of the method according to the present invention for manufacturing a semiconductor element according to the present invention, with reference to a drawing, wherein:

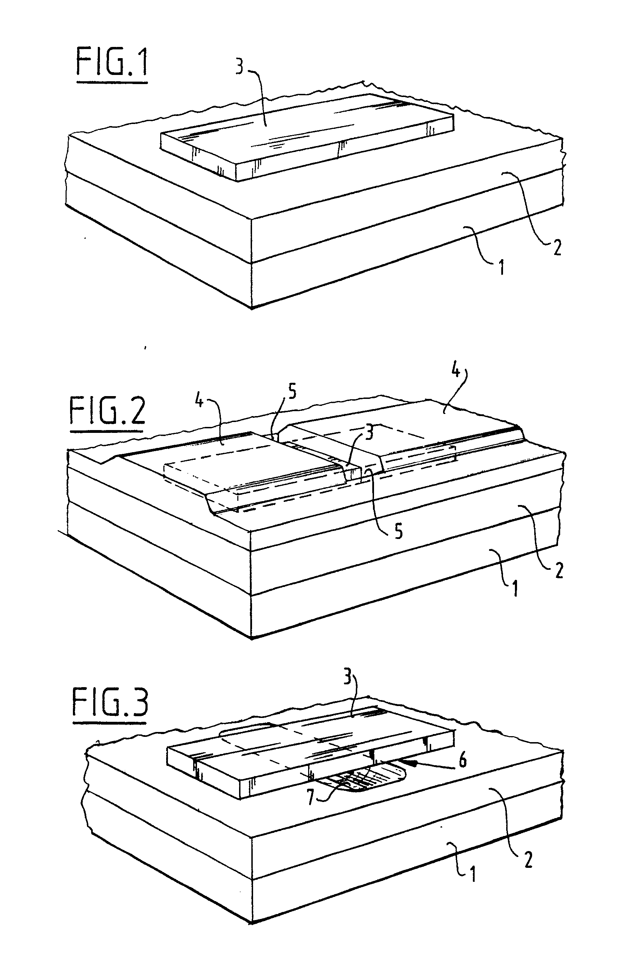

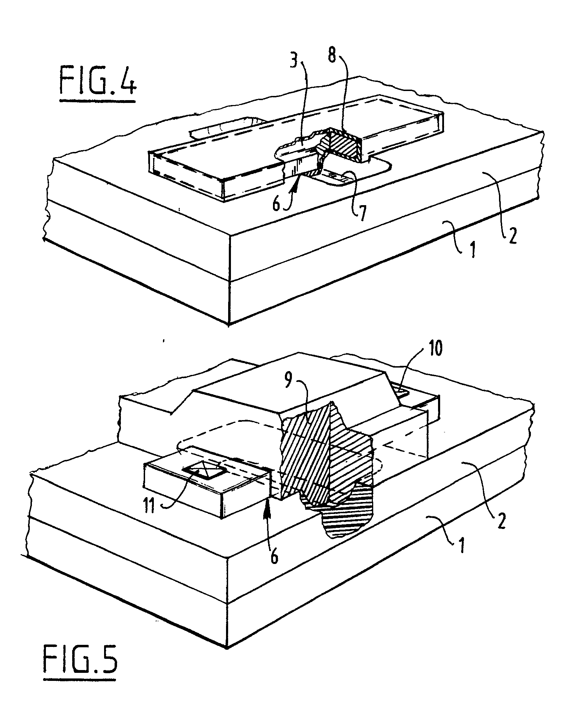

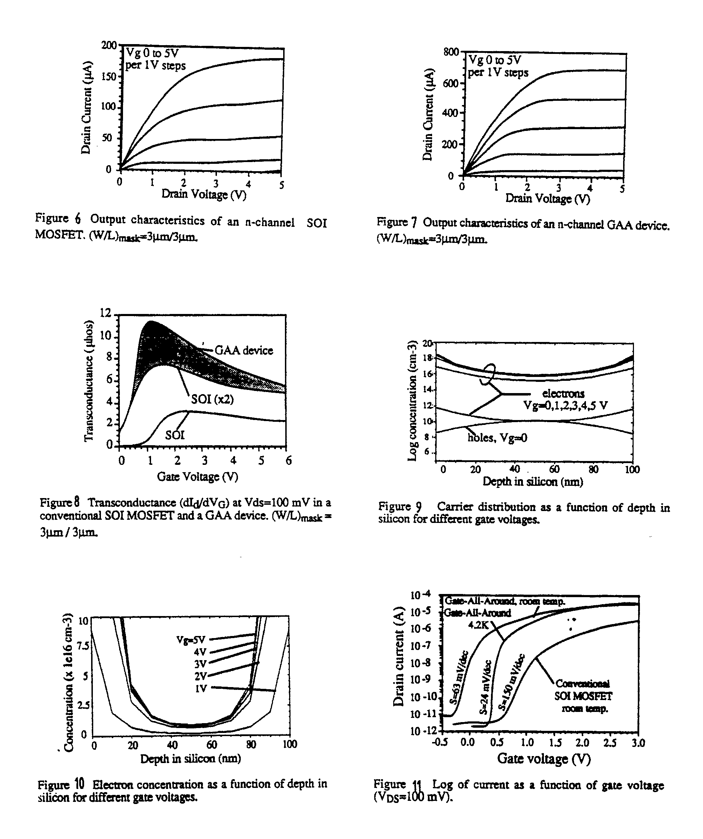

Fig. 1-5 show perspective views of successive process steps for the preferred embodiment of the present invention, wherein fig. 5 shows in perspective the semiconductor element according to the present invention; and figs. 6-10 show a plurality of diagrams for illustrating the present invention. SOI circuits are becoming commercially available to an increasing extent, for instance a 16-bit-$\mu$P (LETI), 256K-SRAM (AT&T) etc.

Applied to a substrate 1 (fig. 1) is an insulating layer 2, preferably of $SiO_2$, whereon an island 3 of semiconductor material, preferably silicon, is arranged. Over this island 3 (fig. 2) a layer of photo coating or resist is subsequently applied, a central area of which is kept free with strips 5 of $SiO_2$ on either side of the island 3.

After selective etching, for instance with a substance containing HF, for a sufficiently long period of time, and the removal of the coating layer 4 there results a bridge portion 6 (fig. 3) of the island 4, under which a cavity 7 is also created by etching.

In the following step (fig. 4) an insulating layer 8, preferably of $SiO_2$, is applied around the exposed portions of the island 4, that is, in the central area 6, around this portion because of the presence of the cavity 7.

Using known art an area 9 of conducting material, preferably of polycrystalline silicon, is subsequently arranged round the central portion 6 of the island 4 (fig. 5), to which a gate contact (not shown) can be attached. After arranging source and drain contact areas 10 and 11 in known manner, a field effect transistor is formed having an extremely thin insulating layer 8 around the channel area 6 of this field effect transistor.

The drawbacks which occur in SOI techniques, that is, a thick back-oxide, are avoided.

Computer simulations have demonstrated that at high radiation levels such a field effect transistor can still be switched off, while with a known SOI field effect transistor this is no longer possible.

Extensive computations have shown in addition that cavities that may occur in the gate of polysilicon have a negligible effect on the operation of the gate.

Boron implantation can be used to enlarge the lateral threshold voltage in order thus to dope the side walls of the island.

The devices according to the present invention are preferably fabricated using a simple 3 μm process and commercial 125 mm SIMOX substrates. The original thickness of the silicon film is 180 nm. A thin pad oxide is grown, and silicon nitride is deposited. Using a mask step, the nitride and the silicon are etched to define the acitve areas. An oxidation step (200 nm oxide) is used to round the edges of the silicon islands, after which the nitride and the pad oxide are stripped. A mask step is then used to cover the entire wafer with resist except areas which correspond to an oversize of the intersection between the active area and the poly gate layers. The wafers are then immersed in buffered HF. At this step the oxide on the sidewalls of the silicon islands as well as the buried oxide are etched, and a cavity is created underneath the center part of the silicon islands. The wafers are removed from BHF once the cavity etch is completed. At this point, the device looks like a silicon bridge supported by its extremities (which will later on become source and drain), which is hanging over an empty cavity. Gate oxidation is then carried out. In this step, a 50 nm-thick gate oxide is grown over all the exposed silicon (top, bottom and edges of the active silicon, as well as on the silicon substrate in the bottom of the cavity). Boron is implanted to adjust the threshold voltage, and polysilicon gate material is then deposited and doped n-type. Because of the extremely good conformality of LPCVD polysilicon, the gate oxide over the cavity is completely coated with polysilicon, and a gate is formed on the top, the sides and the bottom of the channel area (hence the name of gate-all-round (GAA) device). The polysilicon gate is then patterned using conventional lithography and anisotropic plasma etch. Source and drain are formed using phosphorous implantation followed by an annealing step. CVD oxide is deposited, and contact holes are opened. An aluminum metallization step completes the process. The noted difference in grain size in the polysilicon gate layers above and below the device is due to the fact that the polysilicon is doped by heavy phosphorous ion implantation. The upper part of the polysilicon is amorphized during this process, and it recrystallizes into large grains during the subsequent dopant redistribution annealing step (800°C, 8 hours), while the unamorphized bottom polysilicon retains its original asdeposited columnar texture. It is worthwhile mentioning that the only additional steps added to conventional SOI processing for GAA device fabrication are a lithography step and the cavity etch in BHF. Similarly, devices covered with resist during the cavity etch of the GAA process will yield "normal" SOI MOSFET's. The GAA process is much more planar and compatible with classical SOI processing than the previously reported DELTA process which also allows one to fabricate devices with front and back gates, but in which a sidewall of the active silicon island is in contact with a thick field oxide, which can give rise to leakage problems upon dose irradiation.

Figures 6 and 7 present the output characteristics of a conventional n-channel SOI MOSFET and a gate-all-around n-channel device. The final silicon thickness of the conventional device is 125 nm, while the thickness of the GAA device is 100 nm (the GAA device is thinner because gate oxide was grown on both front and back interfaces of the silicon film). The SOI MOSFET is partially depleted. Both devices have the same (drawn) physical dimensions (W/L = 3μm/3μm), but, because of the presence of two channels (at the top and bottom of the silicon film), the effective width of the GAA device is 6 μm. It can be observed that the current drive is much higher in the GAA device than in the SOI transistor. The increased drive is, of course, partly due to the larger effective width (6 μm instead of 3 μm) and to the lower threshold voltage ($V_{th}$ is lower in the GAA device (0.45V) than in the SOI MOSFET (1.2V) because of the thinner silicon film and because of the interaction between the top and bottom depletion zones). But another effect has to be taken into consideration to fully account for the increased drive. This effect is called "volume inversion". It can clearly be observed in fig. 8 where the transconductance of a conventional device and that of a GAA device are compared. An additional curve labeled "SOI x 2" presents the transconductance of the SOI MOSFET multiplied by two and shifted to the left by the difference of threshold voltages ($V_{th,SOI}$ - $V_{th,GAA}$) to account for both the presence of two channels and the lower threshold voltage of the GAA device. The grey area represents the extra drive of the GAA device, which is attributed to volume inversion. Fig. 9 shows that the electron concentration at all depth in the silicon film is much larger than the hole concentration, for all positive gate voltages. The contribution of volume inversion is more pronounced right above threshold, where the inversion layer is distributed across the entire silicon film and where the effects of bulk mobility (in contrast to surface mobility) can be felt. At higher gate voltages, there is still inversion in the center of the silicon film, but the carriers are now mostly localized in inversion layers near the interfaces (fig. 10). As a result, more scattering occurs, and the transconductance tends to be equal to twice that of a conventional device. Because of the excellent coupling between the surface potentials and the gate voltage, a subthreshold slope of 63 mV/decade is obtained at room temperature (vs. 150 mV/decade in the conventional, partially depleted SOI device). (fig. 11). Device measurements were carried at liquid helium temperature (4.2 K) as well. As it was the case at room temperature, no kink is observed in the output characteristics, and the output characteristics are flat (high output impedance). At 4.2 K the subthreshold slope is equal to 24mV/decade and the threshold voltage is 1.1 V (vs. 0.45 V at room temperature) (Fig. 11).

## Claims

1. A method for manufacturing a field effect transistor comprising the following steps of:
- applying an insulating layer on a semiconductor substrate;
- arranging a channel area of semiconductor material on the insulating layer;
- etching the insulating material beneath the channel area;
- applying an insulating layer above and under the channel area;
arranging semiconducting gate material over the insulated channel area; and
- arranging terminals on the channel for source and drain and on the gate material for the gate.

2. A method as claimed in claim 1, wherein etching takes place using a photo coating mask or resist mask.

3. A method as claimed in claim 1 or 2, wherein etching takes place in dry manner, for example using HF.

4. A semiconductor element manufactured according to any of the methods 1-3.

5. A semiconductor element comprising a channel provided with an insulating layer around the channel and semiconducting material around the insulating layer.

6. A semiconductor element as claimed in claim 5, wherein the gate material comprises polycrystalline silicon.

7. A semiconductor element as claimed in claim 5 or 6, wherein the insulating material around the channel has a thickness of 10-20 nm.

FIG.1

FIG.2

FIG.3

FIG.4

FIG.5

Figure 6 Output characteristics of an n-channel SOI MOSFET. (W/L)$_{mask}$=3μm/3μm.

Figure 7 Output characteristics of an n-channel GAA device. (W/L)$_{mask}$=3μm/3μm.

Figure 8 Transconductance (dI$_d$/dV$_G$) at Vds=100 mV in a conventional SOI MOSFET and a GAA device. (W/L)$_{mask}$ = 3μm / 3μm.

Figure 9 Carrier distribution as a function of depth in silicon for different gate voltages.

Figure 10 Electron concentration as a function of depth in silicon for different gate voltages.

Figure 11 Log of current as a function of gate voltage (V$_{DS}$=100 mV).

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 017 709  (ROCKWELL) <br> – – – | | H 01 L 21/86 <br> H 01 L 21/336 |
| A | IEE PROCEEDINGS I. SOLID- STATE & ELECTRON DEVICES. vol. 133, no. 3, June 1986, STEVENAGE GB pages 66 - 76; S.L. PARTRIDGE: "SILICON-ON -INSULATOR TECHNOLOGY" <br> – – – | | |
| A | EP-A-0 077 737  (FAIRCHILD CAMERA AND INSTRUMENT CORPN.) <br> – – – – – | | |

TECHNICAL FIELDS
SEARCHED (Int. Cl.5)

H 01 L

The present search report has been drawn up for all claims

| Place of search | Date of completion of search | Examiner |
|---|---|---|
| The Hague | 16 November 90 | PHEASANT N.J. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document